(19)

Europäisches
Patentamt
European
Patent Office
Office européen
des brevets

(11) **EP 4 550 230 A1**

(12) **EUROPEAN PATENT APPLICATION**

(43) Date of publication:
**07.05.2025   Bulletin 2025/19**

(21) Application number: **24200945.4**

(22) Date of filing: **18.09.2024**

(51) International Patent Classification (IPC):
**G06Q 10/04** (2023.01)      **G06Q 50/02** (2024.01)

(52) Cooperative Patent Classification (CPC):
**G06Q 50/02; G06Q 10/04**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority:   **01.11.2023   IN 202321074468**

(71) Applicant: **Tata Consultancy Services Limited Maharashtra (IN)**

(72) Inventors:
• **SHRIVASTAVA, SURABHI**
  **411057 Pune, Maharashtra (IN)**

• **KAUSLEY, SHANKAR BALAJIRAO**
  **411013 Pune, Maharashtra (IN)**
• **BARAT, SOUVIK**
  **411013 Pune, Maharashtra (IN)**
• **KULKARNI, VINAY**
  **411013 Pune, Maharashtra (IN)**
• **RAI, BEENA**
  **411013 Pune, Maharashtra (IN)**

(74) Representative: **Goddar, Heinz J.**
**Boehmert & Boehmert**
**Anwaltspartnerschaft mbB**
**Pettenkoferstrasse 22**
**80336 München (DE)**

(54) **METHODS AND SYSTEMS FOR PREDICTING WATER QUALITY OF A RIVER HAVING A VARYING RIVER ECOSYSTEM**

(57)    The disclosure relates generally to methods and systems for predicting water quality of a river having a varying river ecosystem. Due to multiple and diverse factors, understanding and estimating the water quality of the river stream (river itself) is extremely and technically challenging. The present disclosure discloses a development of a river digital twin model utilizing a multi-modeling approach to comprehensively model the river and its varying ecosystems. The agents encompass entities that directly or indirectly introduce effluents or withdraw water from the river. Agents and their interactions are defined using a combination of behavior rules, correlations, and physics principles, creating the digital twin model that closely mimics the real river system. Physics-based equations are also employed in the present disclosure to capture the dynamics of the river, while relationships between different agents are established.

FIG. 9

EP 4 550 230 A1

**Description**

CROSS-REFERENCE TO RELATED APPLICATIONS AND PRIORITY

The present application claims priority to Indian application no. 202321074468, filed on November 01, 2023.

TECHNICAL FIELD

The disclosure herein generally relates to the field of water quality monitoring, and more specifically to methods and systems for predicting water quality of a river having a varying river ecosystem.

BACKGROUND

Water is a life source for all life forms. More specifically rivers are the prime sources that provide drinking water for the living beings and the ecosystem. However, water quality of the river is affected due to pollution and effluents that arise from multiple factors including but are not limited to industrial wastage, human needs, and garbage including plastic wastage. Real-time monitoring of the water quality of the river system is a challenging as increase in population and industrialization leading to increase in releasing effluents to river stream is increasing. The current methodologies for estimating river water quality primarily are conventional and traditional techniques that involve the regular monitoring of key parameters such as pH, conductivity, dissolved oxygen, and turbidity.

In the conventional and traditional techniques, sampling of the water is taken from a designated sampling point at different locations and at irregular time intervals for monitoring the water quality of the river. However, these conventional and traditional techniques consume more time, need more water samples (sufficient sample size), and cannot predict actual fluctuations which are happening and the reason behind those fluctuations. Further, the sampling points on the river are scattered and such methods involve low frequency in the samplings.

Further, based on the changes in the source of wastewater getting released into the river, the changes in the quality of the water collection network cannot be predicted beforehand to take necessary actions beforehand. Furthermore, the effects of any streams and its corresponding changes cannot be easily identified by the current quality monitoring techniques, and it is largely dependent on intuition and experience. Modelling the river stream with respect to the multi-heterogenous entities has challenge in analyzing the parameters related to the entities present nearby the river stream. Also, the properties of the water collection network are not only dependent on the incoming streams but also the different factors in the environment and its own properties.

Due to multiple and diverse factors including but are not limited to, changing incoming streams, change in the concentration of effluents because it relates with production volume, population in the residential buildings/societies, change in water consumption patterns and other, change in collection point like volume, exposure to environment and physics of the river system, and understanding and estimating the water quality of the river stream (river itself) is extremely and technically challenging. Hence, an effective monitoring of the water quality of the river at different time instances help to maintain the water quality at desired location and reduce the treatment process steps for using it for any viable purpose or before discharging in any central stream.

SUMMARY

Embodiments of the present disclosure present technological improvements as solutions to one or more of the above-mentioned technical problems recognized by the inventors in conventional systems.

In an aspect, a processor-implemented method for predicting water quality of a river having a varying river ecosystem is provided. The method including the steps of: receiving a layout of a river whose water quality is to be predicted, wherein the layout of the river comprises one or more input sub-streams that flow into a main-stream of the river and one or more output sub-streams that withdraw from the main-stream of the river, one or more river characteristics data of the river, and one or more environmental parameters data; dividing the layout of the river to obtain one or more river segments of the river, based on the one or more input sub-streams, the one or more output sub-streams, the one or more river characteristics of the river, and the one or more environmental parameters, using a multi-criteria decision algorithm; extracting one or more sub-stream agents of each of the one or more input sub-streams present in each river segment of the one or more river segments, using a search algorithm and the layout of the river; classifying each of the one or more sub-stream agents of each of the one or more input sub-streams present in each river segment, with a sub-stream agent type of a plurality of sub-stream agent types, based on one or more agent properties of each of the one or more sub-stream agents, using a classification algorithm; classifying each river segment of the one or more river segments of the river, with a river segment type of a plurality of river segment types, based on (i) a number of the one or more sub-stream agents of each of the one or more input sub-streams present in each river segment, and (ii) the sub-stream agent type of each of the one or more sub-stream agents of each of the one or more input sub-streams present in each river segment; determining an agent parameter value of each of one or more agent parameters defined for each of the one or more sub-stream agents of each of the one or more input sub-streams present in each river segment, using an associated data collected from one or more data collection sources, and based on (i) an associated river segment type, (ii) the sub-stream agent type of each of the one or more sub-stream agents of each of the one or more input sub-streams present in an associated river segment, (iii) the number of the one or more sub-stream agents of each of the one or more input sub-streams present in the associated river segment, (iv) the one or more river characteristics of the associated river segment, and (v) the one or more environmental parameters of the associated river segment, wherein the one or more agent parameters for each sub-stream agent are defined based on an associated sub-stream agent type, and the agent parameter value of each of one or more agent parameters is determined for each time step of a plurality of time steps; modelling a river segment model for each river segment of the one or more river segments of the river, based on the associated river segment type, using a set of rules and a physics-based model; developing a digital twin simulation model of the river, based on (i) the river segment model modelled for each river segment of the one or more river segments of the river, (ii) the agent parameter value of each of the one or more agent parameters defined for each of the one or more sub-stream agents of each of the one or more input sub-streams present in each river segment, determined for each time step of the plurality of time steps, to predict one or more water quality indicators; deciding one or more interventions required to maintain the water quality of the river, based on the one or more water quality indicators predicted and one or more target water quality indicators required; and simulating the water quality of the river based on the one or more interventions required to maintain the water quality of the river, using the digital twin simulation model of the river.

In another aspect, a system for predicting water quality of a river having a varying river ecosystem is provided. The system includes: a memory storing instructions; one or more Input/Output (I/O) interfaces; and one or more hardware processors coupled to the memory via the one or more I/O interfaces, wherein the one or more hardware processors are configured by the instructions to: receive a layout of a river whose water quality is to be predicted, wherein the layout of the river comprises one or more input sub-streams that flow into a main-stream of the river and one or more output sub-streams that withdraw from the main-stream of the river, one or more river characteristics data of the river, and one or more environmental parameters data; divide the layout of the river to obtain one or more river segments of the river, based on the one or more input sub-streams, the one or more output sub-streams, the one or more river characteristics of the river, and the one or more environmental parameters, using a multi-criteria decision algorithm; extract one or more sub-stream agents of each of the one or more input sub-streams present in each river segment of the one or more river segments, using a search algorithm and the layout of the river; classify each of the one or more sub-stream agents of each of the one or more input sub-streams present in each river segment, with a sub-stream agent type of a plurality of sub-stream agent types, based on one or more agent properties of each of the one or more sub-stream agents, using a classification algorithm; classify each river segment of the one or more river segments of the river, with a river segment type of a plurality of river segment types, based on (i) a number of the one or more sub-stream agents of each of the one or more input sub-streams present in each river segment, and (ii) the sub-stream agent type of each of the one or more sub-stream agents of each of the one or more input sub-streams present in each river segment; determine an agent parameter value of each of one or more agent parameters defined for each of the one or more sub-stream agents of each of the one or more input sub-streams present in each river segment, using an associated data collected from one or more data collection sources, and based on (i) an associated river segment type, (ii) the sub-stream agent type of each of the one or more sub-stream agents of each of the one or more input sub-streams present in an associated river segment, (iii) the number of the one or more sub-stream agents of each of the one or more input sub-streams present in the associated river segment, (iv) the one or more river characteristics of the associated river segment, and (v) the one or more environmental parameters of the associated river segment, wherein the one or more agent parameters for each sub-stream agent are defined based on an associated sub-stream agent type, and the agent parameter value of each of one or more agent parameters is determined for each time step of a plurality of time steps; model a river segment model for each river segment of the one or more river segments of the river, based on the associated river segment type, using a set of rules and a physics-based model; develop a digital twin simulation model of the river, based on (i) the river segment model modelled for each river segment of the one or more river segments of the river, (ii) the agent parameter value of each of the one or more agent parameters defined for each of the one or more sub-stream agents of each of the one or more input sub-streams present in each river segment, determined for each time step of the plurality of time steps, to predict one or more water quality indicators; decide one or more interventions required to maintain the water quality of the river, based on the one or more water quality indicators predicted and one or more target water quality indicators required; and simulate the water quality of the river based on the one or more interventions required to maintain the water quality of the river, using the digital twin simulation model of the river.

In yet another aspect, there are provided one or more non-transitory machine-readable information storage mediums comprising one or more instructions which when executed by one or more hardware processors cause: receive a layout of a river whose water quality is to be predicted, wherein the layout of the river comprises one or more input sub-streams that flow into a main-stream of the river and one or more output sub-streams that withdraw from the main-stream of the river, one or more river characteristics data of the river, and one or more environmental parameters data; divide the layout of the river to obtain one or more river segments of the river, based on the one or more input sub-streams, the one or more output sub-streams, the one or more river characteristics of the river, and the one or more environmental parameters, using a multi-criteria decision algorithm; extract one or more sub-stream agents of each of the one or more input sub-streams present in each river segment of the one or more river segments, using a search algorithm and the layout of the river; classify each of the one or more sub-stream agents of each of the one or more input sub-streams present in each river segment, with a sub-stream agent type of a plurality of sub-stream agent types, based on one or more agent properties of each of the one or more sub-stream agents, using a classification algorithm; classify each river segment of the one or more river segments of the river, with a river segment type of a plurality of river segment types, based on (i) a number of the one or more sub-stream agents of each of the one or more input sub-streams present in each river segment, and (ii) the sub-stream agent type of each of the one or more sub-stream agents of each of the one or more input sub-streams present in each river segment; determine an agent parameter value of each of one or more agent parameters defined for each of the one or more sub-stream agents of each of the one or more input sub-streams present in each river segment, using an associated data collected from one or more data collection sources, and based on (i) an associated river segment type, (ii) the sub-stream agent type of each of the one or more sub-stream agents of each of the one or more input sub-streams present in an associated river segment, (iii) the number of the one or more sub-stream agents of each of the one or more input sub-streams present in the associated river segment, (iv) the one or more river characteristics of the associated river segment, and (v) the one or more environmental parameters of the associated river segment, wherein the one or more agent parameters for each sub-stream agent are defined based on an associated sub-stream agent type, and the agent parameter value of each of one or more agent parameters is determined for each time step of a plurality of time steps; model a river segment model for each river segment of the one or more river segments of the river, based on the associated river segment type, using a set of rules and a physics-based model; develop a digital twin simulation model of the river, based on (i) the river segment model modelled for each river segment of the one or more river segments of the river, (ii) the agent parameter value of each of the one or more agent parameters defined for each of the one or more sub-stream agents of each of the one or more input sub-streams present in each river segment, determined for each time step of the plurality of time steps, to predict one or more water quality indicators; decide one or more interventions required to maintain the water quality of the river, based on the one or more water quality indicators predicted and one or more target water quality indicators required; and simulate the water quality of the river based on the one or more interventions required to maintain the water quality of the river, using the digital twin simulation model of the river.

In an embodiment, the one or more river characteristics data of the river comprises a spatio-temporal river-bed elevation data, a spatio-temporal river-bed breadth data, a spatio-temporal river-bed soil type data, a spatio-temporal river-bed depth data, and a river length.

In an embodiment, the one or more environmental parameters data comprises a spatio-temporal rainfall data across the river, a spatio-temporal temperature data across the river, and a spatio-temporal humidity data across the river.

In an embodiment, dividing the layout of the river to obtain one or more river segments of the river, based on the one or more input sub-stream entities, the one or more output sub-stream entities, the one or more river characteristics of the river, and the one or more environmental parameters, using the multi-criteria decision algorithm, comprises: calculating a number of input and output sub-streams, from the one or more input sub-streams and the one or more output sub-streams; calculating a normalized river-bed elevation using the one or more river characteristics of the river; calculating a normalized temperature difference, a normalized rainfall difference, and a normalized humidity difference, from the one or more environmental parameters; calculating a potential number of river segments, based on the number of input and output sub-streams, the normalized river-bed elevation, the normalized temperature difference, the normalized rainfall difference, and the normalized humidity difference; and obtaining the one or more river segments of the river, based on the potential number of river segments and a predefined river segment threshold.

In an embodiment, modelling the river segment model for each river segment of the one or more river segments of the river, based on the associated river segment type, using the set of rules and the physics-based model, comprising: determining one or more interactions between the one or more sub-stream agents of each of the one or more input sub-streams present in each river segment based on the associated river segment type, using the set of rules; and developing the river segment model for each river segment, based on the associated river segment type, and the one or more interactions between the one or more sub-stream agents of each of the one or more input sub-streams present in the associated river segment type, using the physics-based model.

It is to be understood that both the foregoing general description and the following detailed description are exemplary and explanatory only and are not restrictive of the invention, as claimed.

BRIEF DESCRIPTION OF THE DRAWINGS

The accompanying drawings, which are incorporated in and constitute a part of this disclosure, illustrate exemplary embodiments and, together with the description, serve to explain the disclosed principles:

FIG. 1 is an exemplary block diagram of a system for predicting water quality of a river having a varying river ecosystem, in accordance with some embodiments of the present disclosure.

FIG. 2 is an exemplary block diagram illustrating a plurality of modules of the system of FIG. 1, for predicting water quality of a river having a varying river ecosystem, in accordance with some embodiments of the present disclosure.

FIGS. 3A-3B illustrate exemplary flow diagrams of a processor-implemented method for predicting water quality of a river having a varying river ecosystem, using the system of FIG. 1, in accordance with some embodiments of the present disclosure.

FIG. 4 illustrates an exemplary layout of the river, in accordance with some embodiments of the present disclosure.

FIG. 5 is a flowchart comprising steps for dividing the layout of the river to obtain one or more river segments of the river, in accordance with some embodiments of the present disclosure.

FIG. 6 is a flowchart comprising steps for modelling the river segment model for each river segment of the one or more river segments of the river, in accordance with some embodiments of the present disclosure.

FIG. 7 shows exemplary interactions between the one or more sub-stream agents of each of the one or more input sub-streams, in accordance with some embodiments of the present disclosure.

FIG. 8 shows an exemplary river segment model for each river segment, in accordance with some embodiments of the present disclosure.

FIG. 9 shows an exemplary simulated layout of the river, in accordance with some embodiments of the present disclosure.

## DETAILED DESCRIPTION OF EMBODIMENTS

Exemplary embodiments are described with reference to the accompanying drawings. In the figures, the left-most digit(s) of a reference number identifies the figure in which the reference number first appears. Wherever convenient, the same reference numbers are used throughout the drawings to refer to the same or like parts. While examples and features of disclosed principles are described herein, modifications, adaptations, and other implementations are possible without departing from the scope of the disclosed embodiments.

The significance of river water quality is high as it directly influences the well-being of both humans and the ecological environment surrounding it. Rivers serve as crucial sources of a freshwater for many applications including but are not limited to industrial, household, and irrigation purposes, while also supporting diverse ecosystems. It is imperative to prioritize the health and sustainability of the above-mentioned applications by ensuring proper river water quality. Clean river water not only reduces treatment costs and procedures before municipal or industrial water. It is important to maintain the river water quality not only at a specific point for its entire course as it traverses through various challenges and routes including but are not limited to cities, villages, localities, and areas.

Despite having good initial quality, rivers often experience deterioration along their journey due to multiple factors, including but are not limited to industrial effluent discharge, municipal discharges, non-point sources, surface runoff, rainfall, soil erosion, temperature changes, alterations in the area's topology, population demographics, and changes in nutrient levels and biological growth. These factors collectively impact the quality of the river water through various mechanisms and in diverse ways, with their effects continuously varying over time and location. Therefore, it is crucial to comprehensively study and analyze all these factors throughout the course of the river to accurately assess river water quality, propose measures for maintenance, and suggest improvements. Since, the river by nature has a self-cleaning capability and can handle some amount of pollution load, the river quality can be maintained throughout the course with proper measures. Hence it is important to estimate the river water quality so that proper measures can be taken accordingly.

Current techniques employed for estimating the river water quality primarily involve the regular monitoring of key water parameters such as pH, conductivity, dissolved oxygen, and turbidity. This monitoring is typically conducted at discrete locations spaced at significant distances along the river. The measurements are carried out either through manual sample collection followed by laboratory testing or by utilizing remote sensing and automated monitoring stations through data collection.

Various departments especially government bodies and non-governmental organizations (NGOs) are dedicated to river water quality maintenance and restoration often employ automated sensing and sampling techniques. However, the limited and sporadic nature of these measurements fails to provide a comprehensive understanding of the river water quality variations across its entire length, as well as the sources of pollution. Point measurements solely offer information about the specific water parameters but not the underlying factors contributing to deviations in the river water quality. Consequently, while some limited information about the river can be derived from these measurements, they are unable to capture the complexities of the river ecosystem and the dynamic factors influencing its water quality changes.

Various mathematical models are available in literature for simulating and predicting the behavior of river water quality based on historical data. Conventional techniques such as multiple linear regression (MI,R) and the Mann-Kendall (MK) trend test, and data-based models such as Artificial Neural Network (ANN), recurrent neural networks (RNN), genetic programming (GP), support vector machine (SVM), and neuro-fuzzy (NF) models, have been developed as standalone approaches. These models utilize extensive historical data to forecast the quality of the river water at specific locations in the future. However, these methods have limitations. They cannot effectively model or predict phenomena that have not been observed in the past, rendering them inadequate for capturing novel changes in the river ecosystem and their effects on water quality. Furthermore, data-based models are incapable of performing what-if analyses to determine the factors behind deviations in the river water quality.

Several software applications are also available in the art for river modeling and predicting changes in river water quality. However, these software applications primarily focus on hydrodynamics, flow patterns, and the influence of various factors on river flow and dispersion. These models are often rigid in nature and rely on pre-existing relationships and available information, lacking flexibility to incorporate new parameters and effects. Software applications such as MIKE21 and QUAL2E are commonly used for river water modeling, but they primarily emphasize on steady-state flows, flow properties, and water planning systems. The modeling of water quality parameters and their behavior is not given significant importance in these models. Furthermore, these models typically employ fixed quality parameters that cannot be adjusted based on the specific requirements of the user for key parameter indices.

The complexity of rivers and their ecosystems highlights the limitations of singular approaches in modeling the entire river system and its intricacies. Conventional modeling tools fall short in capturing the multitude of factors that influence the river water quality, necessitating a combination of modeling approaches. Each factor impacting river water quality possesses unique attributes and is dependent on environmental conditions. Changes in the environmental factors alter the attributes of these factors, subsequently impacting the river water quality in diverse ways. Moreover, these factors do not operate in isolation; rather, they exhibit interdependence, where changes in one factor trigger changes in others. Such dynamic behaviors can be effectively modeled using agent-based modeling, treating each factor as an agent with its own behaviors and attributes. The relationships between agents are established through correlations, rules, or data-based models.

On the other hand, river flow and changes in water quality properties follow the laws of physics, lending themselves well to physics-based models. Therefore, by combining different modeling approaches, the overall quality of the river water can be accurately predicted, accounting for all factors that influence its quality and effectively modeling the effects of attribute changes on the river water quality.

The present disclosure solves the technical problems in the art with the methods and systems for predicting water quality of the river having the varying river ecosystem. The present disclosure discloses a development of a river digital twin utilizing a multi-modeling approach to comprehensively model the river and its varying ecosystems. The concept of agents is proposed in the present disclosure to represent the river itself and the various factors contributing to changes in the water quality of the river. The agents encompass entities that directly or indirectly introduce effluents or withdraw water from the river, considering attributes that impact the volume and quality parameters of discharge or uptake. A collection of agents interacting with each other are considered in accordance with the physics governing river flow, instead of treating the river as a single agent.

Chemical reactions governing river water quality changes are incorporated into the river agents. Each location is subject to mass balance considerations, accounting for factors such as velocity, length, and breadth of the river. The agents representing households, industries, streams, and wastewater treatment plants (WWTPs) are included, allowing to digital twin model to the effects of their variable attributes on the river. Importantly, the multi-modeling methodology of the present disclosure has the flexibility to accommodate any new factors that may influence river water quality but are not limited to already included in the existing model. The proposed digital twin model combines agent-based modeling (ABM) with other modeling techniques to accurately determine the water quality for the entire length of the river.

Further, the agent-based modeling approach of the present disclosure represents the river and its varying ecosystem. Agents and their interactions are defined using a combination of behavior rules, correlations, and physics principles, creating the digital twin model that closely mimics the real river system. The development of the digital twin model of the river and its simulation encompasses several steps, including defining the agents and categorizing each factor into different agent archetypes. Physics-based equations are employed in the present disclosure to capture the dynamics of the river, while relationships between different agents are established.

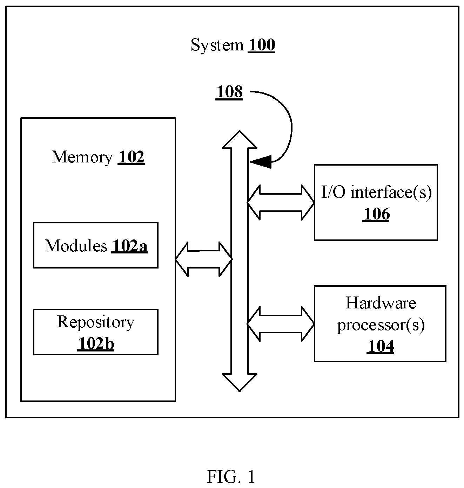

Referring now to the drawings, and more particularly to FIG. 1 through FIG. 9, where similar reference characters denote corresponding features consistently throughout the figures, there are shown preferred embodiments and these embodiments are described in the context of the following exemplary systems and/or methods.

FIG. 1 is an exemplary block diagram of a system 100 for predicting water quality of a river having a varying river ecosystem, in accordance with some embodiments of the present disclosure. In an embodiment, the system 100 includes or is otherwise in communication with one or more hardware processors 104, communication interface device(s) or input/output (I/O) interface(s) 106, and one or more data storage devices or memory 102 operatively coupled to the one or more hardware processors 104. The one or more hardware processors 104, the memory 102, and the I/O interface(s) 106 may be coupled to a system bus 108 or a similar mechanism.

The I/O interface(s) 106 may include a variety of software and hardware interfaces, for example, a web interface, a graphical user interface (GUI), and the like. The I/O interface(s) 106 may include a variety of software and hardware interfaces, for example, interfaces for peripheral device(s), such as a keyboard, a mouse, an external memory, a plurality of sensor devices, a printer and the like. Further, the I/O interface(s) 106 may enable the system 100 to communicate with other devices, such as web servers and external databases.

The I/O interface(s) 106 can facilitate multiple communications within a wide variety of networks and protocol types, including wired networks, for example, local area network (LAN), cable, etc., and wireless networks, such as Wireless LAN (WLAN), cellular, or satellite. For the purpose, the I/O interface(s) 106 may include one or more ports for connecting a number of computing systems with one another or to another server computer. Further, the I/O interface(s) 106 may include one or more ports for connecting a number of devices to one another or to another server.

The one or more hardware processors 104 may be implemented as one or more microprocessors, microcomputers, microcontrollers, digital signal processors, central processing units, state machines, logic circuitries, and/or any devices that manipulate signals based on operational instructions. Among other capabilities, the one or more hardware processors 104 are configured to fetch and execute computer-readable instructions stored in the memory 102. In the context of the present disclosure, the expressions 'processors' and 'hardware processors' may be used interchangeably. In an embodiment, the system 100 can be implemented in a variety of computing systems, such as laptop computers, portable computers, notebooks, hand-held devices, workstations, mainframe computers, servers, a network cloud and the like.

The memory 102 may include any computer-readable medium known in the art including, for example, volatile memory, such as static random access memory (SRAM) and dynamic random access memory (DRAM), and/or non-volatile memory, such as read only memory (ROM), erasable programmable ROM, flash memories, hard disks, optical disks, and magnetic tapes. In an embodiment, the memory 102 includes a plurality of modules 102a and a repository 102b for storing data processed, received, and generated by one or more of the plurality of modules 102a. The plurality of modules 102a may include routines, programs, objects, components, data structures, and so on, which perform particular tasks or implement particular abstract data types.

The plurality of modules 102a may include programs or computer-readable instructions or coded instructions that supplement applications or functions performed by the system 100. The plurality of modules 102a may also be used as, signal processor(s), state machine(s), logic circuitries, and/or any other device or component that manipulates signals based on operational instructions. Further, the plurality of modules 102a can be used by hardware, by computer-readable instructions executed by the one or more hardware processors 104, or by a combination thereof. In an embodiment, the plurality of modules 102a can include various sub-modules (not shown in FIG. 1). Further, the memory 102 may include information pertaining to input(s)/output(s) of each step performed by the processor(s) 104 of the system 100 and methods of the present disclosure.

The repository 102b may include a database or a data engine. Further, the repository 102b amongst other things, may serve as a database or includes a plurality of databases for storing the data that is processed, received, or generated as a result of the execution of the plurality of modules 102a. Although the repository 102b is shown internal to the system 100, it will be noted that, in alternate embodiments, the repository 102b can also be implemented external to the system 100, where the repository 102b may be stored within an external database (not shown in FIG. 1) communicatively coupled to the system 100. The data contained within such external database may be periodically updated. For example, data may be added into the external database and/or existing data may be modified and/or non-useful data may be deleted from the external database. In one example, the data may be stored in an external system, such as a Lightweight Directory Access Protocol (LDAP) directory and a Relational Database Management System (RDBMS). In another embodiment, the data stored in the repository 102b may be distributed between the system 100 and the external database.

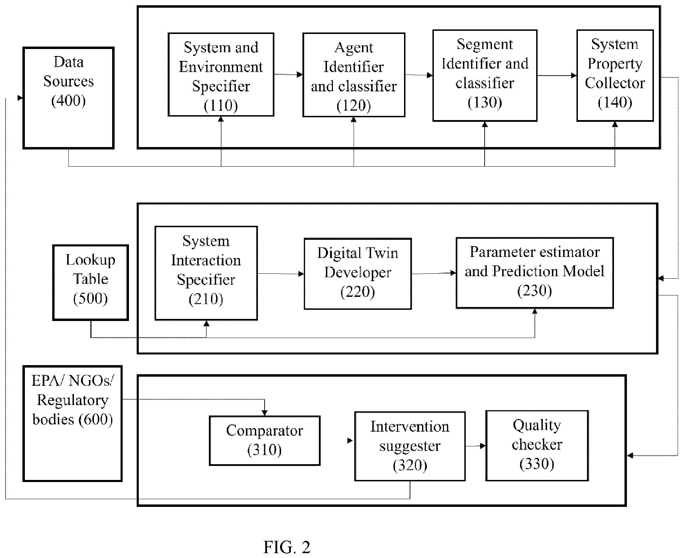

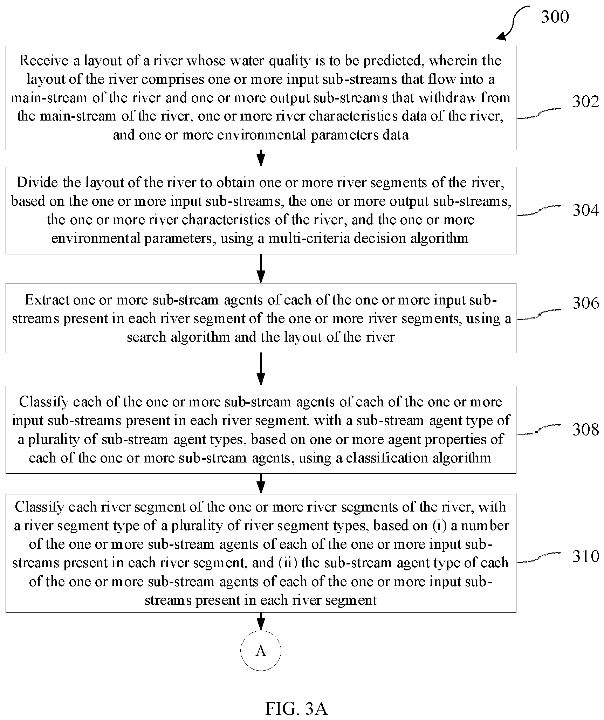

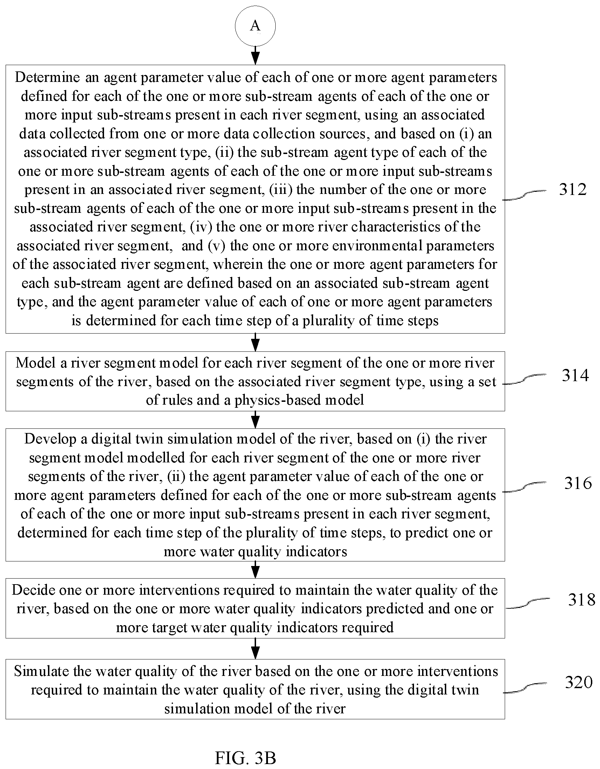

Referring collectively to FIG. 2 and FIGS. 3A-3B, components and functionalities of the system 100 are described in accordance with an example embodiment of the present disclosure. For example, FIG. 2 is an exemplary block diagram illustrating the plurality of modules 102a of the system 100 of FIG. 1, for predicting water quality of a river having a varying river ecosystem, in accordance with some embodiments of the present disclosure. In an embodiment, the plurality of modules 102a includes a system and environment specifier 110, an agent identifier and classifier 120, a segment identifier and classifier 130, a system property collector 140, a system interaction specifier 210, a digital twin developer 220, a parameter estimator and prediction model 230, a comparator 310, an intervention suggester 320, a quality checker 330, data sources 400, a look-up table 500, and regulatory bodies 600.

For example, FIGS. 3A-3B illustrate exemplary flow diagrams of a processor-implemented method 300 for predicting water quality of a river having a varying river ecosystem, using the system 100 of FIG. 1, in accordance with some embodiments of the present disclosure. Although steps of the method 300 including process steps, method steps, techniques or the like may be described in a sequential order, such processes, methods, and techniques may be configured to work in alternate orders. In other words, any sequence or order of steps that may be described does not necessarily indicate a requirement that the steps be performed in that order. The steps of processes described herein may be performed in any practical order. Further, some steps may be performed simultaneously, or some steps may be performed alone or independently.

At step 302 of the method 300, the one or more hardware processors 104 of the system 100 are configured to receive a layout of a river whose water quality is to be predicted. In an embodiment, the layout of the river comprises one or more input sub-streams that flow into a main-stream of the river and one or more output sub-streams that withdraw from the main-stream of the river, one or more river characteristics of the river, and one or more environmental parameters. In an embodiment, the one or more input sub-streams and the one or more output sub-streams are represented as entities of the river.

In an embodiment, the one or more river characteristics data of the river includes a spatio-temporal river-bed elevation data across the river, a spatio-temporal river-bed breadth data across the river, a spatio-temporal river-bed soil type data across the river, a spatio-temporal river-bed depth data across the river, and a river length. In an embodiment, the river length is defined as the distance between the starting point where it is originated and an ending point where it will end or merge into another river or directly into the ocean. In an embodiment, the starting point of the river and the ending point of the river are defined by user based on the requirement and accordingly the river length is considered. In an embodiment, the one or more river characteristics data of the river is received from the data sources 400 by the system and the environment specifier 110. In an embodiment, the data sources 400 include all the data repositories and databases collected from various sources including but are not limited to sensor data, meteorological data, user defined data, other collection sources.

In an embodiment, the one or more environmental parameter data include a spatio-temporal rainfall data across the river, a spatio-temporal temperature data across the river, and a spatio-temporal humidity data across the river. The spatio-temporal temperature data across the river and the spatio-temporal humidity data across the river are considered to estimate the evaporation rate of the river water in the form of spatio-temporal format. In an embodiment, the one or more environmental parameters are received from the data sources 400 by the system and the environment specifier 110.

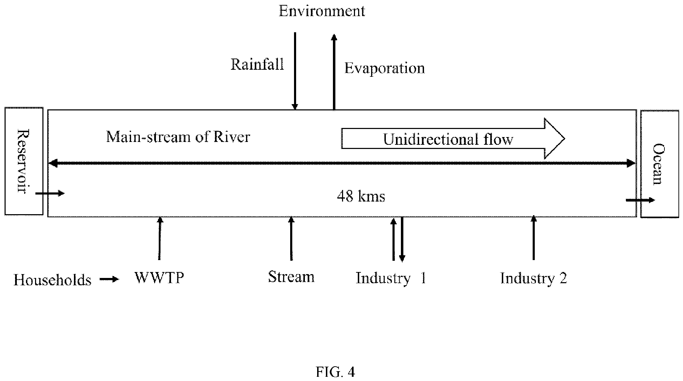

FIG. 4 illustrates an exemplary layout of the river, in accordance with some embodiments of the present disclosure. In FIG. 4, the input sub-streams such as 'households', 'WWTP', 'stream', 'industry 1', and 'industry 2' that flow into the main-stream of the river, and the output sub-streams such as 'industry 1' that withdraw from the main-stream of the river are shown in the exemplary layout. In FIG. 4, the entity 'industry 1' is shown as both the input sub-stream and the output sub-stream. Further, the main-stream of the river may diverse into small patches, however including the small patches are considered as the main-stream. The starting point of the river is shown as the 'reservoir' where the main-stream starts, and the ending point of the river is shown as the 'ocean' where the main-stream joins the ocean in a unidirectional flow. The river length is shown as 48 kilometers (kms). The one or more environmental parameters shown are rainfall and evaporation related parameters.

Table 1 shows some of the exemplary river characteristics and the exemplary environmental parameters of the river:

Table 1

| River distance from start (km) | River-bed height (m) | Average Temperature (°C) | River surface area (km$^2$) | Average Rainfall (mm) | River-bed particle size (mm) |
|---|---|---|---|---|---|
| 1 | 2 | 25 | 10 | 80 | 1.8 |
| 2 | 2 | 25 | 10 | 80 | 1.8 |
| 5 | 2 | 28 | 10 | 80 | 1.8 |
| 10 | 2 | 29 | 10 | 80 | 1.8 |
| 12 | 2 | 30 | 10 | 80 | 1.8 |
| 15 | 2 | 30 | 10 | 80 | 1.8 |
| 18 | 2 | 30 | 10 | 80 | 1.8 |
| 22 | 2 | 32 | 10 | 80 | 1.8 |
| 25 | 2 | 32 | 10 | 80 | 1.8 |
| 30 | 2 | 32 | 10 | 80 | 1.8 |
| 32 | 2 | 32 | 10 | 80 | 1.8 |
| 36 | 2 | 32 | 10 | 80 | 1.8 |
| 40 | 2 | 32 | 10 | 80 | 1.8 |
| 42 | 2 | 32 | 10 | 80 | 1.8 |

(continued)

| River distance from start (km) | River-bed height (m) | Average Temperature (°C) | River surface area (km²) | Average Rainfall (mm) | River-bed particle size (mm) |
|---|---|---|---|---|---|
| 48 | 2 | 32 | 10 | 80 | 1.8 |

At step 304 of the method 300, the one or more hardware processors 104 of the system 100 are configured to divide the layout of the river received at step 302 of the method 300, to obtain one or more river segments of the river. The layout of the river is divided based on the one or more input sub-streams, the one or more output sub-streams, the one or more river characteristics of the river, and the one or more environmental parameters received at step 302 of the method 300. Further, a multi-criteria decision algorithm is employed to divide the layout of the river to obtain one or more river segments of the river. In an embodiment, the segment identifier and classifier 130 is configured to obtain one or more river segments of the river.

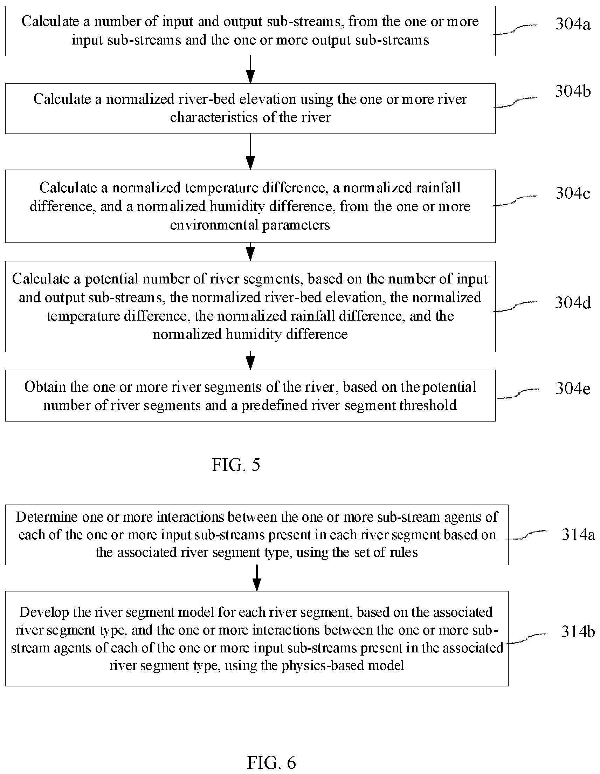

FIG. 5 is a flowchart comprising steps for dividing the layout of the river to obtain the one or more river segments of the river, in accordance with some embodiments of the present disclosure. As shown in FIG. 5, the steps 304a to 304e explains dividing the layout of the river to obtain the one or more river segments of the river.

At step 304a, a number of input and output sub-streams is calculated from the one or more input sub-streams and the one or more output sub-streams received at step 302 of the method 300. More specifically, the number of input and output sub-streams ($S$) is the sum of the number of the one or more input sub-streams and the number of the one or more output sub-streams.

At next step 304b, a normalized river-bed elevation is calculated using the one or more river characteristics of the river received at step 302 of the method 300. More specifically the normalized river-bed elevation ($E_{Normalized}$) is calculated as:

$$E_{Normalized} = \frac{initial\ river\ bed\ height - final\ river\ bed\ height}{initial\ river\ bed\ height} \qquad (1)$$

At step 304c, a normalized temperature difference, a normalized rainfall difference, and a normalized humidity difference, are calculated from the one or more environmental parameters received at step 302 of the method 300. More specifically, normalized temperature difference ($T_{Normalized}$), a normalized rainfall difference ($R_{Normalized}$), and a normalized humidity difference ($H_{Normalized}$) are calculated as:

$$T_{Normalized} = \frac{lowest\ temperature - heightest\ temperature}{lowest\ temperature} \qquad (2)$$

$$R_{Normalized} = \frac{lowest\ rainfall - heightest\ rainfall}{lowest\ rainfall} \qquad (3)$$

$$H_{Normalized} = \frac{lowest\ humidity - heightest\ humidity}{lowest\ humidity} \qquad (4)$$

Next at step 304c, a potential number of river segments is calculated based on the number of input and output sub-streams ($S$), the normalized river-bed elevation ($E_{Normalized}$), the normalized temperature difference ($T_{Normalized}$), the normalized rainfall difference ($R_{Normalized}$), and the normalized humidity difference ($H_{Normalized}$) (304d). More specifically the potential number of river segments ($R_{Poten\_segments}$) is calculated using the below equation:

$$R_{Poten\_segments} = w_1 S + w_2 E_{Normalized} + w_3 T_{Normalized} +$$

$$w_4 R_{Normalized} + w_5 H_{Normalized} \qquad (5)$$

wherein $w_1$, $w_2$, $w_3$, $w_4$, $w_5$ are weights defined by the user.

At last step 304d, the one or more river segments of the river are obtained based on the potential number of river segments and a predefined river segment threshold, based on the river length. If the potential number of river segments is greater than the predefined river segment threshold, the one or more river segments are obtained by considering the predefined river segment threshold, else the one or more river segments are obtained by considering the potential number of river segments.

More specifically based on the river length, initially, predefined segment of the river is considered first applied the steps 304a through 304d to check the feasibility on the number of the one or more river segments each having a number of the input sub-streams and the output sub-steams. If there is no feasibility, then the initially predefined segment is added with some more length and accordingly performed so that the one or more river segments of the river are obtained are feasible enough and quantifiable to define each parameter associated with each river segment.

At step 306 of the method 300, the one or more hardware processors 104 of the system 100 are configured to extract one or more sub-stream agents of each of the one or more input sub-streams present in each river segment of the one or more river segments. A text-based search algorithm is employed and using the layout of the river, to extract the one or more sub-stream agents of each input sub-stream present in each river segment. In this case, the one or more output sub-streams present in each river segment are ignored assuming that they may not affect the quality of river water as they just withdraw from the river and never joins back into the river. In an embodiment, the agent identifier and classifier 120 is configured to extract one or more sub-stream agents of each of the one or more input sub-streams present in each river segment of the one or more river segments.

The agent-based modeling approach is adopted to model the complex river water quality factors by defining each contributing entity as sub-stream agents (or simply agents). This agent-based modeling approach allows us to comprehensively represent the effects of these factors on the river, considering the heterogeneity of the river system. Notably, to incorporate the heterogeneity of the river in the model, the river itself is represented as a combination of multiple agents, each defined by a distinct value of its attributes and behaviors, with mathematical equations governing the interactions between them and with different agents. In an embodiment, Python programming language may be utilized and by employing an object-oriented methodology to define the agents. Each agent was conceptualized as a class, encapsulating the behaviors, and attributes specific to its role. The instantiation of each class was achieved through parameterization, using time series inputs that reflect the evolving dynamics of the system.

For example, the sub-stream agent list includes but is not limited to industry, household, streams, wastewater treatment plant (WWTP), river, reservoir, rainfall, and area. Each agent has its one or more agent parameters defined based on the nature of the agent. For example, the agent parameters for the agent household includes number of members present in house/colony/area, amount of water intake, amount of water/pollutants released, frequency of usage, frequency of release and so on. In another example, the agent parameters for the agent industry includes a type of industry, amount of chemicals released into input stream that joins the main-stream, amount of river water intake, and so on. Each agent is individually defined as a separate class within the model, and specific attributes are assigned based on their properties, which significantly influence river water quality.

For example, Industry agents are characterized by attributes such as 'daily production' and 'effluent parameters', with the latter containing a list of qualitative and quantitative values, including 'volume of effluent', 'Biochemical Oxygen Demand (BOD) of effluent', and 'Dissolved Oxygen (DO) of effluent'. Similarly, household and stream agents possess 'effluent parameters' with the same set of values as industry agents. The WWTP agent features 'volume' and 'removal efficiency' attributes, while the reservoir agent includes 'volume', 'height', 'BOD', and 'DO' attributes. The river agent encompasses 'breadth', 'length', 'velocity', 'BOD', and 'DO' attributes, representing key parameters of the river. Considering the environmental factors, the rainfall is also modeled as an agent to efficiently capture its impact and dependencies within the system. It takes attribute of 'rainfall in mm' and 'quality of rainfall' i.e., BOD and DO. Moreover, an area agent is defined, incorporating attributes such as 'rainfall in mm' and 'temperature'.

In determining the number of river agents for a specific river section, a direct approach is not applicable, as it heavily relies on the complexity of the river system. Assigning each 1 km section as an individual agent would result in a computationally expensive process and may not provide additional relevant information at such a granular level. Therefore, a careful selection of the number of agents is essential to balance accounting for the river system's heterogeneity while avoiding unnecessary computational overhead. To address this challenge, an algorithm defining the steps 304a through 304d is employed to estimate the optimal number of river agents. The algorithm considers the intricacies of the river system and ensures that the model captures the relevant features without compromising computational efficiency.

At step 308 of the method 300, the one or more hardware processors 104 of the system 100 are configured to classify each of the one or more sub-stream agents extracted at step 306 of the method 300, with a sub-stream agent type, based on one or more agent properties associated to the corresponding sub-stream agent. The sub-stream agent type is one of a plurality of sub-stream agent types which is a list of all influencing types including but are not limited to household type, industry type, WWTP type, steam type, and so on. In an embodiment, the agent identifier and classifier 120 is configured to classify each of the one or more sub-stream agents with the suitable sub-stream agent type based on one or more agent properties associated to the corresponding sub-stream agent.

A classification algorithm is employed to classify each sub-stream agent with the suitable sub-stream agent type from the plurality of sub-stream agent types. In an embodiment, the classification algorithm is one of a rule-based classification model or a machine learning (ML) based classification model. Table 2 shows exemplary list of sub-stream agents classified to corresponding sub-stream agent type.

Table 2

| Sub-stream Agent | Sub-stream Agent type |
|---|---|
| Industry | Industry |
| Factory | Industry |
| Plant | Industry |
| Mill | Industry |
| Nala | Stream |
| Sewer | Stream |
| Non-point source | Stream |
| Tributary | Stream |
| Stream | Stream |
| WWTP | WWTP |
| Treatment plant | WWTP |
| Wastewater plant | WWTP |
| Biological reactor | WWTP |
| Household | Household |
| Locality | Household |
| Society | Household |
| Blocks | Household |
| Ocean | Reservoir |
| Dam | Reservoir |
| Embankment | Reservoir |

At step 310 of the method 300, the one or more hardware processors 104 of the system 100 are configured to classify each river segment of the one or more river segments of the river, obtained at step 304 of the method 300. with a river segment type. The river segment type is one of a plurality of river segment types defined based on corresponding characteristics. In an embodiment, the segment identifier and classifier 130 is configured to classify each river segment of the one or more river segments of the river, with a suitable river segment type.

Each river segment is classified with a suitable river segment type, based on (i) the number of the one or more sub-stream agents of each of the one or more input sub-streams present in the corresponding river segment, and (ii) the sub-stream agent type of each of the one or more sub-stream agents of each of the one or more input sub-streams present in the corresponding river segment.

As mentioned at step 308 of the method 300, the classification algorithm is employed to classify each river segment with the suitable river segment type from the plurality of river segment types. In an embodiment, the classification algorithm is one of the rule-based classification models, or the machine learning (ML) based classification model.

Within each agent, distinct behaviors are established, and a group of entities within each agent belongs to a particular section. To facilitate the simulation of large systems and organize similar behaviors, different river segment types are introduced, grouping related behaviors together. Each entity within an agent is associated with a suitable river segment type, determining its set of rules and behaviors. To accommodate agents with behaviors that may significantly vary based on different parameters, distinct river segment types are assigned according to the parameters that influence the modeling process. For instance, the river agents are given two river segment types based on river depth and riverbed particle size. These two factors significantly impact the river's reaeration rate by altering turbulence and velocity, thereby influencing the river's self-cleaning capability. Table 3 shows exemplary list of river segment types used to classify each river segment type based on the river characteristics of the river and based on the input and output streams:

Table 3

| Based on river depth | Based on river bed particle size | Based on input output streams |
|---|---|---|
| Type A - 0-1 m | Type A - <2 mm | Type A - more than 2 input-streams for type A industry |
| Type B - 1-4 m | Type B - 2-64 mm | |
| Type C - >4 m | Type C - 64-250 mm | Type B - more than 2 input-streams for type B industry |
| | Type D - >250 mm | |

In a similar manner, the river segment types for industry and household agents are also established. For household agents, the population density is utilized as a factor to define the agent archetypes. The population density significantly influences the quality and volume of wastewater discharged, as areas with higher population density, such as slums or small localities, may lack proper water treatment facilities, while larger buildings may have in-house treatment and reuse provisions.

The classification of industry river segment types is based on the specific type of industry it represents, as this significantly influences the nature of effluent discharge and the feasibility of pollutant treatment naturally, ultimately impacting the environment. Additionally, the river segment types are determined by the treatment methodologies employed by the industries. By combining these two defining factors, a total of 32 distinct industry river segment types may be established.

Table 4 shows exemplary list of river segment types used to classify each river segment type based on the type of industry and treatment type processed in each industry:

Table 4

| Based on Type of industry | Based on treatment type |
|---|---|
| Type A - Oil refineries | Type A - In-house within CPCB limits |
| Type B - Paper industries | Type B - Direct discharge |
| Type C - textile industries | Type C - Discharge to municipalities |
| Type D - Sugar mills | |
| Type E - Pharmaceutical | |
| Type F - Chemical industries | Type D - No discharge |
| Type G - Brewery Industries | |
| Type H - Other industries | |

Table 5 shows exemplary list of river segment types used to classify each river segment type based on the streams, household density, WWTP of the river and the reservoir type from which the river is originated:

Table 5

| Streams (Type) | Household (Population Density) | WWTP (Type) | Reservoir |
|---|---|---|---|
| Type A - Non-point source | Type A - 20-200/km$^2$ | Type A - Membrane Biological Reactor | Type A - Ocean |
| Type B - Tributary | Type B - 200-400/km$^2$ | Type B - Activated Sludge Reactor | Type B - lake |
| Type C - Runoff | Type C - 400-600/km$^2$ | Type C - Moving Bed Biological Reactor | Type C - Storage/Conservation Reservoir |
| Type D - Sewer drain | Type D - 600-900/km2 | Type D - Rotating Biological Reactor | Type D - Distributor Reservoir |
| | Type E - >900/km2 | | Type E - Multipurpose Reservoir |

As shown in Table 3, Table 4, and Table 5, the plurality of river segment types is defined based on certain characteristics that defines most the given river segment and out of all the possible river segment types, the river segment type that highly influencing most for the associated river segment.

At step 312 of the method 300, the one or more hardware processors 104 of the system 100 are configured to determine an agent parameter value of each of one or more agent parameters defined for each of the one or more sub-stream agents of each of the one or more input sub-streams present in each river segment. The one or more agent parameters for each sub-stream agent are defined based on an associated sub-stream agent type, as described at step 306 of the method 300. The agent parameter value of each of one or more agent parameters is determined for each time step (Time-step data) of a plurality of time steps given the period. For example, time step is 2 minutes, and the period is 5 days. In an embodiment, the agent parameter value of each of one or more agent parameters defined for each of the one or more sub-stream agents, is determined from the data sources 400 by the system property collector 140.

The agent parameter value of agent parameter defined for each sub-stream agent is determined, using an associated data collected from one or more data collection sources, and based on (i) an associated river segment type, (ii) the sub-stream agent type of each of the one or more sub-stream agents of each of the one or more input sub-streams present in an associated river segment, (iii) the number of the one or more sub-stream agents of each of the one or more input sub-streams present in the associated river segment, (iv) the one or more river characteristics of the associated river segment, and (v) the one or more environmental parameters of the associated river segment. The associated data is collected from one or more data collection sources such as sensors, existing data bases and the domain knowledge.

Table 6 shown the exemplary agent parameter value data for some of the agent parameters defined for some of the sub-stream agents based on the sub-stream agent type:

Table 6

| Agent type | Parameter | Value |
|---|---|---|
| Reservoir 1 | Flow rate | 2000 m$^3$/day |
| | BOD | 2 mg/L |
| | DO | 7.8 mg/L |
| Industry 1 | Production | 52 m$^3$/day |
| | CPCB limit BOD | 30 mg/L |
| Industry 1 | Volume | 200 m$^3$/day |
| Industry 2 | Effluent | 600 m$^3$/day |
| | CPCB Limit BOD | 30 mg/L |
| Stream | Volume discharge | 400 m$^3$/day |
| | BOD | 140 mg/L |
| WWTP | Efficiency | 0.7 |
| | Capacity | 27 MLD |
| Household | Total population | 1,00,000 |
| | Effluent volume per capita | 154 L/day |
| | BOD | 33 mg/L |
| Area 1 | Rainfall | 120 mm |
| | Temperature | 25 |
| ....... | ....... | .......... |
| Area 10 | Rainfall | 120 mm |
| | Temperature | 25 |

At step 314 of the method 300, the one or more hardware processors 104 of the system 100 are configured to model a river segment model for each river segment of the one or more river segments of the river obtained at step 304 of the method 300. The river segment model for each river segment is modelled based on the associated river segment type, using a set of rules and a physics-based model.

FIG. 6 is a flowchart comprising steps for modelling the river segment model for each river segment of the one or more river segments of the river, in accordance with some embodiments of the present disclosure. As shown in FIG. 6, at step 314a, one or more interactions between the one or more sub-stream agents of each of the one or more input sub-streams present in the corresponding river segment, are determined based on the associated river segment type, using the set of rules. Different agents interact with each other in the environment to form the interconnected system which represents the river and its varying ecosystem. Each agent plays a role in influencing the river water quality, either positively or negatively, by directly or indirectly interacting with the river agent. These interactions are modeled using correlations based on historical data or observed behavioral patterns.

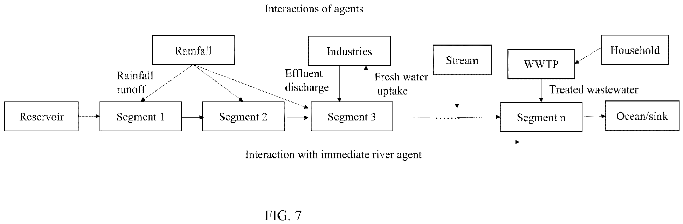

FIG. 7 shows exemplary interactions between the one or more sub-stream agents of each of the one or more input sub-streams, in accordance with some embodiments of the present disclosure. Moreover, interactions among river agents themselves are governed by the set of rules defined through flow dynamics. For example, a specific river agent solely interacts with its neighboring agents. It receives stream input from the preceding agent, and after undergoing processes such as mixing, pollutant degradation, and oxygen consumption, it discharges water to the succeeding agent. Importantly, the model does not consider backflow and hence, any agent only transfers water downstream to the next agent in line and not in the reverse direction. In the model, effluent streams from industry, streams, household, and WWTP are either added to the river or, in some cases, taken up for their use. These direct additions or take-ups of water contribute to the river's dynamics.

However, no other interactions between these agents and the river agent are assumed. The reservoir, depending on its location and specific factors such as height and total rainfall, may discharge water to the river or take up water from it. The discharge flow from the reservoir is regulated by various influencing factors. Furthermore, rainfall directly adds water to the river, and the relationship between rainfall in millimeters and the corresponding volume added to the river is expressed by the equation provided by below equation:

$$V_{\text{rain}} = 4.856 + (0.035 \times P - 0.0769 \times T) + (1.137 \times 10^{-6} \times P \times T) - (2.296 \times 10^{-4} \times P^2) + (1.098 \times 10^{-3} \times T^2) + (1.152 \times 10^{-5} \times P^2 \times T) - (5.931 \times 10^{-5} \times P \times T^2) \qquad (6)$$

Where P is monthly average rainfall in mm, $T$ is the temperature, and $V_{rain}$ is water influx in river due to rainfall m³/day. The above equation can be converted to daily rainfall data for finding daily influx of water in river due to rainfall. The area agent gives information about the temperature and rainfall to the river, which in turn estimates the rate of evaporation and water influx to the system.

In certain scenarios, the household and industry agents may also directly interact with the wastewater treatment plant (WWTP). Depending on the situation, they may discharge water to the WWTP, which subsequently releases treated water back into the river. The WWTP, in turn, receives inputs from industry or household agents. Additionally, the rainfall contributes to the water influx in the WWTP. The model accounts for the influx of water in the WWTP due to rainfall using the below equation which enables the accurate representation of the impact of rainfall on the WWTP's water inflow.

$$V_{rainWWTP} = (1.48P + 935.35) \times 1000 \qquad (7)$$

Where $P$ is monthly average rainfall in mm and $V_{rainWWTP}$ in water influx in river due to rainfall m³/day. The households and industries are also correlated, as the number of industries increase, number of households in the area also increase. Those relationships are not defined in the model but can be modelled for establishing further dependencies between different agents.

Next at step 314b, the river segment model for each river segment, is developed based on the associated river segment type, and the one or more interactions between the one or more sub-stream agents of each of the one or more input sub-streams present in the associated river segment type, using the physics-based model.

The agent-based modeling approach contributes to the heterogeneity and complexity of the system, allowing for a comprehensive representation of interactions and dependencies within the river model. However, it is vital to incorporate the inherent physics of the river, which governs processes such as pollutant degradation and oxygen dissolution from the air. These physics-based equations play a crucial role in modeling the chemical degradation of pollutants, oxygen consumption, and the replenishment of oxygen from the atmosphere, ensuring accurate predictions of quality parameter variations over time and space. The physics of the river in form of equations are incorporated in the river class representing river agent.

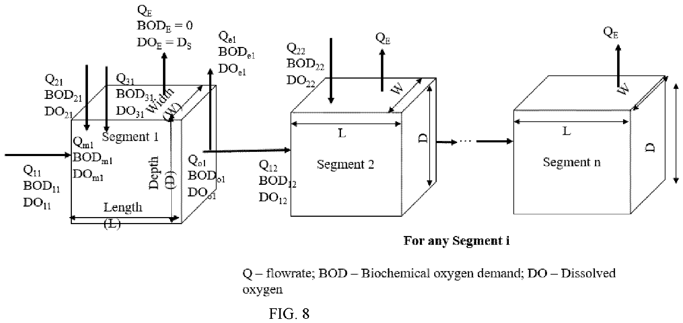

FIG. 8 shows an exemplary river segment model for each river segment, in accordance with some embodiments of the present disclosure. To account for the mixing of different streams, a mass balance equation is employed, wherein volumes are added, and quality parameters (BOD and DO) are calculated as weighted averages of the mixing streams. These equations are denoted in below equations, allowing for a precise representation of the mixing processes and their impact on the river water quality at the point of mixing.

$$Q_{mi} = Q_{1i} + Q_{2i} + Q_{3i} + \cdots Q_{li} - Q_E \qquad (8)$$

The above equation represents the mixing of different streams at the start of an $i^{th}$ river agent, where $Q_{1i}$ is inlet from previous agent of river/reservoir and $Q_{2i}$ to $Q_{li}$ is inlet from external agents (industries, WWTP, rainfall), $Q_E$ is volume loss by evaporation. Quality parameters i.e., BOD and DO change due to mixing is represented by below equations.

$$BOD_{mi} = \frac{Q_{1i} \times BOD_{1i} + Q_{2i} \times BOD_{2i} + Q_{3i} \times BOD_{3i} + \cdots Q_{li} \times BOD_{li}}{Q} \qquad (9)$$

$$DO_{mi} = \frac{Q_{1i} \times DO_{1i} + Q_{2i} \times DO_{2i} + Q_{3i} \times DO_{3i} + \cdots Q_{li} \times DO_{li}}{Q_{mi}} \qquad (10)$$

The evaporation from the river surface can be estimated from the modified Penman-Monteith equation, suggested by Valiantzas. The equation 4 describes the evaporation rate in mm/day.

$$E = 0.047 \times R_S \sqrt{T + 9.5} - 2.4 \left(\frac{R_S}{R_A}\right)^2 + 0.09(T + 20)\left(1 - \frac{RH}{100}\right) \qquad (11)$$

Where $R_S$ denotes the solar radiation and extra-terrestrial radiation, respectively in MJm$^{-2}$d. $RH$ is relative humidity (%) and $T$ is temperature in degree Celsius. $T$, $RH$ and $R_S$ are parameters available in weather reports and $R_A$ can be estimated for empirical relation. The evaporation in m3/day can be calculated by multiplying evaporation by length ($L$) and width ($W$) of the river of that agent. The BOD and DO of the river agent are instantiated by the mass balance equation but it changes as it leaves the agent to the other agents according to the below equations.

$$BOD_{oi} = \frac{BOD_{mi}}{(1 + k_{di}\tau_i)} \qquad (12)$$

$$DO_{oi} = \frac{DO_{mi} + k_{ri}D_s\tau_i - k_{di}\left(\frac{BOD_{mi}}{1 + k_{di}\tau_i}\right)\tau_i}{(1 + k_{ri}\tau_i)} \qquad (13)$$

Where $k_{di}$ and $k_{ri}$ is the BOD degradation coefficient and reaeration coefficient of the particular river section/agent which depends on the temperature, velocity, riverbed properties. $BOD_{mi}$ and $DO_{mi}$ is the mixed BOD and DO values, respectively calculated from mass balance equations at the inlet of any river agent. $D_s$ is the saturation DO, which is dependent on the temperature of the river section. $\tau_i$ is calculated by dividing volume of the river section ($L \times W \times D$) with the total flow in the river section $Q_{mi}$.

Similarly, any other physics of the system can be added in the river class to include more dynamics or behavior in the river system such as algal growth or erosion of the riverbed, etc.

At step 316 of the method 300, the one or more hardware processors 104 of the system 100 are configured to develop a digital twin simulation model of the river, based on the (i) the river segment model modelled for each river segment of the one or more river segments of the river, (ii) the agent parameter value of each of one or more agent parameters defined for each of the one or more sub-stream agents of each of the one or more input sub-streams present in each river segment, determined for each time step of the plurality of time steps. In an embodiment, the digital twin developer 220 is configured to develop the digital twin simulation model of the river. The digital twin simulation model of the river is employed to predict one or more water quality indicators of the river. In an embodiment, the parameter estimator and prediction model 230 is configured to predict one or more water quality indicators of the river. In an embodiment, the one or more water quality indicators includes but are not limited to BOD and DO. The look-up table 500 is utilized which includes various data required to predict one or more water quality indicators of the river.

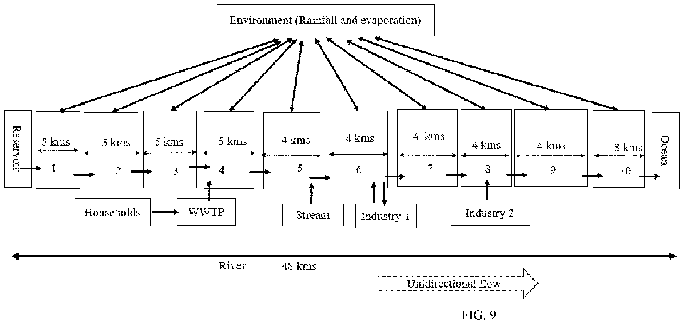

The development of a river digital twin simulation model involves creating a simulated representation of the actual river and its varying ecosystem, closely resembling the real system, using a simulation tool. FIG. 9 shows an exemplary simulated layout of the river, in accordance with some embodiments of the present disclosure.

To construct the river digital twin simulation model, the total length of the river to be modeled is determined, along with the specific section of interest. Various agents (entities) that interact with the river by discharging or withdrawing water are identified, including households, industries, streams, treated effluent from wastewater treatment plants (WWTPs), and runoff. The precise locations of these entities are recorded in relation to the starting point of the river. Additionally, any reservoirs present along the course of the river are accounted for in the digital twin simulation model. The river and its varying ecosystem exist within an environment that interacts with them. This interaction includes factors such as rainfall, which introduces water into the system, and temperature, which contributes to evaporation from both the river and its varying ecosystem.

These sub-stream agents are implemented through class definitions in Python, enabling the representation of their distinct behaviors and interactions within the river digital twin simulation model. The assignment of specific attributes to each class ensures a comprehensive simulation of the river system, allowing for the incorporation of relevant dependencies and the accurate representation of water quality dynamics.

The sub-stream agents defined for the representative river are presented as an example case. However, the river digital twin simulation model can be extended to include additional agents, along with their specific attributes and behaviors, to encompass a wider range of factors and their influence on river water quality. This adaptability ensures that the model can be tailored to specific river systems, accommodating various scenarios, and facilitating a deeper understanding and factors influencing river water quality.

At step 318 of the method 300, the one or more hardware processors 104 of the system 100 are configured to decide one or more interventions required to maintain the water quality of the river, based on the one or more water quality indicators predicted and one or more target water quality indicators required to maintain the required quality. The comparator 310 is configured to compare the one or more water quality indicators predicted and one or more target water quality indicators required.

The intervention suggester 320 is configured to decide one or more interventions required to maintain the water quality of the river through the regulatory bodies 600, based on the comparison results obtained by the comparator 310. In an embodiment, the regulatory bodies 600 includes but are not limited to government agencies, non-profit organizations (NGOs), and environmental protection agencies (EPAs).

At step 320 of the method 300, the one or more hardware processors 104 of the system 100 are configured to simulate the water quality of the river based on the one or more interventions required to maintain the water quality of the river, through the quality checker 330. The digital twin simulation model of the river obtained at step 316 of the method 300 is employed to simulate to quantify the water quality of the river after implementing the one or more interventions. In an embodiment, the results obtained from the various modules are stored in the data sources 400 for future use.

The methods and systems of the present disclosure develops the river digital twin simulation model utilizing a multi-modeling approach to comprehensively model the river and its varying ecosystems. The concept of agents is proposed in the present disclosure to represent the river itself and the various factors contributing to changes in the water quality of the river. The agents encompass entities that directly or indirectly introduce effluents or withdraw water from the river, considering attributes that impact the volume and quality parameters of discharge or uptake.

The collection of agents interacting with each other are considered in accordance with the physics governing river flow, instead of treating the river as a single agent. Chemical reactions governing river water quality changes are incorporated into the river agents. Importantly, the multi-modeling methodology of the present disclosure has the flexibility to accommodate any new factors that may influence river water quality but are not limited to already included in the existing model. The proposed digital twin model combines agent-based modeling (ABM) with other modeling techniques to accurately determine the water quality for the entire length of the river.

Further, the agent-based modeling approach of the present disclosure represents the river and its varying ecosystem. Agents and their interactions are defined using a combination of behavior rules, correlations, and physics principles, creating the digital twin model that closely mimics the real river system. The development of the digital twin model of the river and its simulation encompasses several steps, including defining the agents and categorizing each factor into different agent archetypes. Physics-based equations are employed in the present disclosure to capture the dynamics of the river, while relationships between different agents are established.

Example scenario:

The methods and systems of the present disclosure is demonstrated as the use case comprises a unidirectional river with a length of 48 km. The river originates from a reservoir and terminates at the ocean which is another form of reservoir. The river is assumed to have a one-way flow without any backflow or intermixing. Two industries are situated at distances of 28 km and 36 km from the starting point of the river. The ecosystem includes a household that collects and redirects all its wastewater to a wastewater treatment plant (WWTP), which subsequently releases the treated water into the river at a location 15 km from the starting point. Additionally, a stream originates from a non-point source located 23 km from the starting point of the river. Industry 1, situated at the 28 km mark, also withdraws water from the river. The river and its ecosystem are situated within an environment that introduces rainfall based on recorded data specific to the area, considering the location and time of year. Moreover, the temperature of the environment affects the rate of evaporation from the river, reservoir, and other open water bodies.

The agent-based simulation is implemented using the MESA framework package available in Python. Different agents are defined using classes, which allow for the encoding of their respective behaviors. To achieve a realistic representation of the system, simultaneous activation is adopted as the type of activation, considering that all activities occur simultaneously within the model. The simulation progresses in discrete time steps, with each step equivalent to one day. To ensure this, all effluent discharge volumes, rainfall volumes, and other quantities are expressed in metric cubic meters per day.

The volumes of effluent discharge and their respective qualities are instantiated for each agent in the simulation. At the beginning of the simulation, all river agents are set to have a BOD value of 25 mg/L and a DO value of 8 mg/L. Similarly, the reservoir's water quality is initialized with a BOD of 10 mg/L and a DO of 8.4 mg/L. To estimate the total effluent generated by the household agents, the average per capita wastewater generation is considered, which is 154 L/day in summer (April - September) and 116 L/day in winter (October - March) as reported by Rathnavaka et al. This value is then multiplied by the total number of people in the household, providing the total effluent volume generated from each household. The quality of the wastewater is also estimated based on Rathnavaka et al.'s work. The average BOD from a household is found to be 33 mg/L, and the relationship between BOD and COD (Chemical Oxygen Demand) is defined as BOD = 0.66*COD + 0.16. It's essential to consider variations in average BOD based on different household types, accounting for the definition of different archetypes.

In this study, the capacity of the WWTP is set at 27 metric litres per day (MLD) with an efficiency of 70%. The effluent generated by industry 1 is dependent on its daily production. For archetype G in category 1 of industries, the effluent discharge is 4.88 times the production rate. With an average production of 52 $m^3$/day and belonging to archetype A in category 2 of industries, industry 1's effluent discharge complies with CPCB limits, resulting in a BOD of 30 mg/L and a DO of 5.8 mg/L. Similarly, for industry 2, the daily effluent discharge is 600 $m^3$/day with the same BOD and DO values as industry 1 due to their identical archetypes in category B. Industry 1 draws 200 $m^3$/day of water from the river at the same quality as the river water at that specific point. The stream agent exhibits a daily discharge of 540 $m^3$/day, characterized by a BOD of 200 mg/L and a DO of 4.2 mg/L.

For the system simulation, the river's velocity is assumed to be constant, and any increase in water volume may alter the depth of various river sections while maintaining a constant overall velocity. The daily rainfall data for a specific locality is obtained from the meteorological website and incorporated into the model. The BOD of the rainfall is assumed to zero and the DO is that of saturation value i.e., 8.4 mg/L. The rainfall and temperature values are assumed to be consistent for all river agents to simplify calculations. Once all the necessary values are instantiated, the model is executed over the course of a year, enabling the prediction of water quality for different sections of the river (i.e., each agent) over time. This comprehensive simulation approach facilitates a thorough assessment of the river's water quality dynamics, considering various interactions and factors influencing the system.

Results and Discussion

In this study, the agent-based model combined with the physics-based representation of the river was subjected to a year-long simulation, where each time step corresponds to a single day. The resulting water quality of each agent was extracted as output and plotted over time and distance. To evaluate the quality variation with distance, a representative distance of 5 km was chosen, and at every 5 km interval, the water quality of the encountered agent was considered. For enhanced visualization and data analysis, shorter distances can also be utilized. The simulations are carried out to predict the BOD and DO at different time steps and distances. For the initial simulation run, the model was simulated for 10 days.

The written description describes the subject matter herein to enable any person skilled in the art to make and use the embodiments. The scope of the subject matter embodiments is defined by the claims and may include other modifications that occur to those skilled in the art. Such other modifications are intended to be within the scope of the claims if they have similar elements that do not differ from the literal language of the claims or if they include equivalent elements with insubstantial differences from the literal language of the claims.

The embodiments of present disclosure herein address unresolved problem of predicting the water quality of the river having the varying river ecosystem. The present disclosure discloses a development of a river digital twin utilizing a multi-modeling approach to comprehensively model the river and its varying ecosystems.

It is to be understood that the scope of the protection is extended to such a program and in addition to a computer-readable means having a message therein; such computer-readable storage means contain program-code means for implementation of one or more steps of the method, when the program runs on a server or mobile device or any suitable programmable device. The hardware device can be any kind of device which can be programmed including e.g., any kind of computer like a server or a personal computer, or the like, or any combination thereof. The device may also include means which could be e.g., hardware means like e.g., an application-specific integrated circuit (ASIC), a field-programmable gate array (FPGA), or a combination of hardware and software means, e.g., an ASIC and an FPGA, or at least one microprocessor and at least one memory with software processing components located therein. Thus, the means can include both hardware means, and software means. The method embodiments described herein could be implemented in hardware and software. The device may also include software means. Alternatively, the embodiments may be implemented on different hardware devices, e.g., using a plurality of CPUs.

The embodiments herein can comprise hardware and software elements. The embodiments that are implemented in software include but are not limited to, firmware, resident software, microcode, etc. The functions performed by various components described herein may be implemented in other components or combinations of other components. For the purposes of this description, a computer-usable or computer readable medium can be any apparatus that can comprise, store, communicate, propagate, or transport the program for use by or in connection with the instruction execution system, apparatus, or device.

The illustrated steps are set out to explain the exemplary embodiments shown, and it should be anticipated that ongoing technological development will change the manner in which particular functions are performed. These examples are presented herein for purposes of illustration, and not limitation. Further, the boundaries of the functional building blocks have been arbitrarily defined herein for the convenience of the description. Alternative boundaries can be defined so long as the specified functions and relationships thereof are appropriately performed. Alternatives (including equivalents, extensions, variations, deviations, etc., of those described herein) will be apparent to persons skilled in the relevant art(s) based on the teachings contained herein. Such alternatives fall within the scope of the disclosed embodiments. Also, the words "comprising," "having," "containing," and "including," and other similar forms are intended to be equivalent in meaning and be open ended in that an item or items following any one of these words is not meant to be an exhaustive listing of such item or items or meant to be limited to only the listed item or items. It must also be noted that as used herein and in the appended claims, the singular forms "a," "an," and "the" include plural references unless the context clearly dictates otherwise.

Furthermore, one or more computer-readable storage media may be utilized in implementing embodiments consistent with the present disclosure. A computer-readable storage medium refers to any type of physical memory on which information or data readable by a processor may be stored. Thus, a computer-readable storage medium may store instructions for execution by one or more processors, including instructions for causing the processor(s) to perform steps or stages consistent with the embodiments described herein. The term "computer-readable medium" should be understood to include tangible items and exclude carrier waves and transient signals, i.e., be non-transitory. Examples include random access memory (RAM), read-only memory (ROM), volatile memory, nonvolatile memory, hard drives, CD ROMs, DVDs, flash drives, disks, and any other known physical storage media.

It is intended that the disclosure and examples be considered as exemplary only, with a true scope of disclosed embodiments being indicated by the following claims.

**Claims**

1. A processor-implemented method (300), comprising the steps of:

receiving, via one or more hardware processors, a layout of a river whose water quality is to be predicted, wherein the layout of the river comprises one or more input sub-streams that flow into a main-stream of the river and one or more output sub-streams that withdraw from the main-stream of the river, one or more river characteristics data of the river, and one or more environmental parameters data (302);
dividing, via the one or more hardware processors, the layout of the river to obtain one or more river segments of the river, based on the one or more input sub-streams, the one or more output sub-streams, the one or more river characteristics of the river, and the one or more environmental parameters, using a multi-criteria decision algorithm (304);
extracting, via the one or more hardware processors, one or more sub-stream agents of each of the one or more input sub-streams present in each river segment of the one or more river segments, using a search algorithm and the layout of the river (306);
classifying, via the one or more hardware processors, each of the one or more sub-stream agents of each of the one or more input sub-streams present in each river segment, with a sub-stream agent type of a plurality of sub-stream agent types, based on one or more agent properties of each of the one or more sub-stream agents, using a classification algorithm (308);
classifying, via the one or more hardware processors, each river segment of the one or more river segments of the river, with a river segment type of a plurality of river segment types, based on (i) a number of the one or more sub-stream agents of each of the one or more input sub-streams present in each river segment, and (ii) the sub-stream agent type of each of the one or more sub-stream agents of each of the one or more input sub-streams present in each river segment (310);
determining, via the one or more hardware processors, an agent parameter value of each of one or more agent parameters defined for each of the one or more sub-stream agents of each of the one or more input sub-streams present in each river segment, using an associated data collected from one or more data collection sources, and based on (i) an associated river segment type, (ii) the sub-stream agent type of each of the one or more sub-stream agents of each of the one or more input sub-streams present in an associated river segment, (iii) the number of the one or more sub-stream agents of each of the one or more input sub-streams present in the associated river segment, (iv) the one or more river characteristics of the associated river segment, and (v) the one or more environmental parameters of the associated river segment, wherein the one or more agent parameters for each sub-stream agent are defined based on an associated sub-stream agent type, and the agent parameter value of each of one or more agent parameters is determined for each time step of a plurality of time steps (312);

modelling, via the one or more hardware processors, a river segment model for each river segment of the one or more river segments of the river, based on the associated river segment type, using a set of rules and a physics-based model (314); and

developing, via the one or more hardware processors, a digital twin simulation model of the river, based on (i) the river segment model modelled for each river segment of the one or more river segments of the river, (ii) the agent parameter value of each of the one or more agent parameters defined for each of the one or more sub-stream agents of each of the one or more input sub-streams present in each river segment, determined for each time step of the plurality of time steps, to predict one or more water quality indicators (316).

2. The processor-implemented method as claimed in claim 1, wherein the one or more river characteristics data of the river comprises a spatio-temporal river-bed elevation data, a spatio-temporal river-bed breadth data, a spatio-temporal river-bed soil type data, a spatio-temporal river-bed depth data, and a river length.

3. The processor-implemented method as claimed in claim 1, wherein the one or more environmental parameters data comprises a spatio-temporal rainfall data across the river, a spatio-temporal temperature data across the river, and a spatio-temporal humidity data across the river.

4. The processor-implemented method as claimed in claim 1, wherein dividing the layout of the river to obtain one or more river segments of the river, based on the one or more input sub-stream entities, the one or more output sub-stream entities, the one or more river characteristics of the river, and the one or more environmental parameters, using the multi-criteria decision algorithm, comprises:

calculating a number of input and output sub-streams, from the one or more input sub-streams and the one or more output sub-streams (304a);

calculating a normalized river-bed elevation using the one or more river characteristics of the river (304b);

calculating a normalized temperature difference, a normalized rainfall difference, and a normalized humidity difference, from the one or more environmental parameters (304c);

calculating a potential number of river segments, based on the number of input and output sub-streams, the normalized river-bed elevation, the normalized temperature difference, the normalized rainfall difference, and the normalized humidity difference (304d); and

obtaining the one or more river segments of the river, based on the potential number of river segments and a predefined river segment threshold (304e).

5. The processor-implemented method as claimed claim 1, wherein modelling the river segment model for each river segment of the one or more river segments of the river, based on the associated river segment type, using the set of rules and the physics-based model, comprising:

determining one or more interactions between the one or more sub-stream agents of each of the one or more input sub-streams present in each river segment based on the associated river segment type, using the set of rules (314a); and

developing the river segment model for each river segment, based on the associated river segment type, and the one or more interactions between the one or more sub-stream agents of each of the one or more input sub-streams present in the associated river segment type, using the physics-based model (314b).

6. The processor-implemented method as claimed in claim 1, further comprising:

deciding, via the one or more hardware processors, one or more interventions required to maintain the water quality of the river, based on the one or more water quality indicators predicted and one or more target water quality indicators required (318); and

simulating, via the one or more hardware processors, the water quality of the river based on the one or more interventions required to maintain the water quality of the river, using the digital twin simulation model of the river (320).

7. A system (100) comprising:

a memory (102) storing instructions;
one or more input/output (I/O) interfaces (106); and
one or more hardware processors (104) coupled to the memory (102) via the one or more I/O interfaces (106), wherein the one or more hardware processors (104) are configured by the instructions to:

receive a layout of a river whose water quality is to be predicted, wherein the layout of the river comprises one or more input sub-streams that flow into a main-stream of the river and one or more output sub-streams that withdraw from the main-stream of the river, one or more river characteristics data of the river, and one or more environmental parameters data;

divide the layout of the river to obtain one or more river segments of the river, based on the one or more input sub-streams, the one or more output sub-streams, the one or more river characteristics of the river, and the one or more environmental parameters, using a multi-criteria decision algorithm;

extract one or more sub-stream agents of each of the one or more input sub-streams present in each river segment of the one or more river segments, using a search algorithm and the layout of the river;

classify each of the one or more sub-stream agents of each of the one or more input sub-streams present in each river segment, with a sub-stream agent type of a plurality of sub-stream agent types, based on one or more agent properties of each of the one or more sub-stream agents, using a classification algorithm;

classify each river segment of the one or more river segments of the river, with a river segment type of a plurality of river segment types, based on (i) a number of the one or more sub-stream agents of each of the one or more input sub-streams present in each river segment, and (ii) the sub-stream agent type of each of the one or more sub-stream agents of each of the one or more input sub-streams present in each river segment;

determine an agent parameter value of each of one or more agent parameters defined for each of the one or more sub-stream agents of each of the one or more input sub-streams present in each river segment, using an associated data collected from one or more data collection sources, and based on (i) an associated river segment type, (ii) the sub-stream agent type of each of the one or more sub-stream agents of each of the one or more input sub-streams present in an associated river segment, (iii) the number of the one or more sub-stream agents of each of the one or more input sub-streams present in the associated river segment, (iv) the one or more river characteristics of the associated river segment, and (v) the one or more environmental parameters of the associated river segment, wherein the one or more agent parameters for each sub-stream agent are defined based on an associated sub-stream agent type, and the agent parameter value of each of one or more agent parameters is determined for each time step of a plurality of time steps;

model a river segment model for each river segment of the one or more river segments of the river, based on the associated river segment type, using a set of rules and a physics-based model; and

develop a digital twin simulation model of the river, based on (i) the river segment model modelled for each river segment of the one or more river segments of the river, (ii) the agent parameter value of each of the one or more agent parameters defined for each of the one or more sub-stream agents of each of the one or more input sub-streams present in each river segment, determined for each time step of the plurality of time steps, to predict one or more water quality indicators.

8. The system as claimed in claim 7, wherein the one or more river characteristics data of the river comprises a spatio-temporal river-bed elevation data, a spatio-temporal river-bed breadth data, a spatio-temporal river-bed soil type data, a spatio-temporal river-bed depth data, and a river length.

9. The system as claimed in claim 7, wherein the one or more environmental parameters data comprises a spatio-temporal rainfall data across the river, a spatio-temporal temperature data across the river, and a spatio-temporal humidity data across the river.

10. The system as claimed in claim 7, wherein the one or more hardware processors (104) are configured to divide the layout of the river to obtain one or more river segments of the river, based on the one or more input sub-stream entities, the one or more output sub-stream entities, the one or more river characteristics of the river, and the one or more environmental parameters, using the multi-criteria decision algorithm, by:

calculating a number of input and output sub-streams, from the one or more input sub-streams and the one or more output sub-streams;

calculating a normalized river-bed elevation using the one or more river characteristics of the river;

calculating a normalized temperature difference, a normalized rainfall difference, and a normalized humidity difference, from the one or more environmental parameters;

calculating a potential number of river segments, based on the number of input and output sub-streams, the normalized river-bed elevation, the normalized temperature difference, the normalized rainfall difference, and the normalized humidity difference; and

obtaining the one or more river segments of the river, based on the potential number of river segments and a predefined river segment threshold.

11. The system as claimed in claim 7, wherein the one or more hardware processors (104) are configured to model the river segment model for each river segment of the one or more river segments of the river, based on the associated river segment type, using the set of rules and the physics-based model, by:

determining one or more interactions between the one or more sub-stream agents of each of the one or more input sub-streams present in each river segment based on the associated river segment type, using the set of rules; and

developing the river segment model for each river segment, based on the associated river segment type, and the one or more interactions between the one or more sub-stream agents of each of the one or more input sub-streams present in the associated river segment type, using the physics-based model.

12. The system as claimed in claim 7, wherein the one or more hardware processors (104) are further configured to:

decide one or more interventions required to maintain the water quality of the river, based on the one or more water quality indicators predicted and one or more target water quality indicators required; and

simulate the water quality of the river based on the one or more interventions required to maintain the water quality of the river, using the digital twin simulation model of the river.

13. One or more non-transitory machine-readable information storage mediums comprising one or more instructions which when executed by one or more hardware processors cause:

receiving a layout of a river whose water quality is to be predicted, wherein the layout of the river comprises one or more input sub-streams that flow into a main-stream of the river and one or more output sub-streams that withdraw from the main-stream of the river, one or more river characteristics data of the river, and one or more environmental parameters data;

dividing the layout of the river to obtain one or more river segments of the river, based on the one or more input sub-streams, the one or more output sub-streams, the one or more river characteristics of the river, and the one or more environmental parameters, using a multi-criteria decision algorithm;

extracting one or more sub-stream agents of each of the one or more input sub-streams present in each river segment of the one or more river segments, using a search algorithm and the layout of the river;

classifying each of the one or more sub-stream agents of each of the one or more input sub-streams present in each river segment, with a sub-stream agent type of a plurality of sub-stream agent types, based on one or more agent properties of each of the one or more sub-stream agents, using a classification algorithm;

classifying river segment of the one or more river segments of the river, with a river segment type of a plurality of river segment types, based on (i) a number of the one or more sub-stream agents of each of the one or more input sub-streams present in each river segment, and (ii) the sub-stream agent type of each of the one or more sub-stream agents of each of the one or more input sub-streams present in each river segment;

determining an agent parameter value of each of one or more agent parameters defined for each of the one or more sub-stream agents of each of the one or more input sub-streams present in each river segment, using an associated data collected from one or more data collection sources, and based on (i) an associated river segment type, (ii) the sub-stream agent type of each of the one or more sub-stream agents of each of the one or more input sub-streams present in an associated river segment, (iii) the number of the one or more sub-stream agents of each of the one or more input sub-streams present in the associated river segment, (iv) the one or more river characteristics of the associated river segment, and (v) the one or more environmental parameters of the associated river segment, wherein the one or more agent parameters for each sub-stream agent are defined based on an associated sub-stream agent type, and the agent parameter value of each of one or more agent parameters is determined for each time step of a plurality of time steps;

modelling a river segment model for each river segment of the one or more river segments of the river, based on the associated river segment type, using a set of rules and a physics-based model; and
developing a digital twin simulation model of the river, based on (i) the river segment model modelled for each river segment of the one or more river segments of the river, (ii) the agent parameter value of each of the one or more agent parameters defined for each of the one or more sub-stream agents of each of the one or more input sub-streams present in each river segment, determined for each time step of the plurality of time steps, to predict one or more water quality indicators.

14. The one or more non-transitory machine-readable information storage mediums as claimed in claim 13, wherein the one or more instructions which when executed by the one or more hardware processors further cause:

deciding one or more interventions required to maintain the water quality of the river, based on the one or more water quality indicators predicted and one or more target water quality indicators required; and
simulating the water quality of the river based on the one or more interventions required to maintain the water quality of the river, using the digital twin simulation model of the river.

FIG. 1

FIG. 2

300

Receive a layout of a river whose water quality is to be predicted, wherein the layout of the river comprises one or more input sub-streams that flow into a main-stream of the river and one or more output sub-streams that withdraw from the main-stream of the river, one or more river characteristics data of the river, and one or more environmental parameters data — 302

Divide the layout of the river to obtain one or more river segments of the river, based on the one or more input sub-streams, the one or more output sub-streams, the one or more river characteristics of the river, and the one or more environmental parameters, using a multi-criteria decision algorithm — 304

Extract one or more sub-stream agents of each of the one or more input sub-streams present in each river segment of the one or more river segments, using a search algorithm and the layout of the river — 306

Classify each of the one or more sub-stream agents of each of the one or more input sub-streams present in each river segment, with a sub-stream agent type of a plurality of sub-stream agent types, based on one or more agent properties of each of the one or more sub-stream agents, using a classification algorithm — 308

Classify each river segment of the one or more river segments of the river, with a river segment type of a plurality of river segment types, based on (i) a number of the one or more sub-stream agents of each of the one or more input sub-streams present in each river segment, and (ii) the sub-stream agent type of each of the one or more sub-stream agents of each of the one or more input sub-streams present in each river segment — 310

A

FIG. 3A

A

Determine an agent parameter value of each of one or more agent parameters defined for each of the one or more sub-stream agents of each of the one or more input sub-streams present in each river segment, using an associated data collected from one or more data collection sources, and based on (i) an associated river segment type, (ii) the sub-stream agent type of each of the one or more sub-stream agents of each of the one or more input sub-streams present in an associated river segment, (iii) the number of the one or more sub-stream agents of each of the one or more input sub-streams present in the associated river segment, (iv) the one or more river characteristics of the associated river segment, and (v) the one or more environmental parameters of the associated river segment, wherein the one or more agent parameters for each sub-stream agent are defined based on an associated sub-stream agent type, and the agent parameter value of each of one or more agent parameters is determined for each time step of a plurality of time steps ⌐ 312

Model a river segment model for each river segment of the one or more river segments of the river, based on the associated river segment type, using a set of rules and a physics-based model ⌐ 314

Develop a digital twin simulation model of the river, based on (i) the river segment model modelled for each river segment of the one or more river segments of the river, (ii) the agent parameter value of each of the one or more agent parameters defined for each of the one or more sub-stream agents of each of the one or more input sub-streams present in each river segment, determined for each time step of the plurality of time steps, to predict one or more water quality indicators ⌐ 316

Decide one or more interventions required to maintain the water quality of the river, based on the one or more water quality indicators predicted and one or more target water quality indicators required ⌐ 318

Simulate the water quality of the river based on the one or more interventions required to maintain the water quality of the river, using the digital twin simulation model of the river ⌐ 320

FIG. 3B

FIG. 4

Calculate a number of input and output sub-streams, from the one or more input sub-streams and the one or more output sub-streams ⌐ 304a

↓

Calculate a normalized river-bed elevation using the one or more river characteristics of the river ⌐ 304b

↓

Calculate a normalized temperature difference, a normalized rainfall difference, and a normalized humidity difference, from the one or more environmental parameters ⌐ 304c

↓

Calculate a potential number of river segments, based on the number of input and output sub-streams, the normalized river-bed elevation, the normalized temperature difference, the normalized rainfall difference, and the normalized humidity difference ⌐ 304d

↓

Obtain the one or more river segments of the river, based on the potential number of river segments and a predefined river segment threshold ⌐ 304e

FIG. 5

Determine one or more interactions between the one or more sub-stream agents of each of the one or more input sub-streams present in each river segment based on the associated river segment type, using the set of rules ⌐ 314a

↓

Develop the river segment model for each river segment, based on the associated river segment type, and the one or more interactions between the one or more sub-stream agents of each of the one or more input sub-streams present in the associated river segment type, using the physics-based model ⌐ 314b

FIG. 6

Interactions of agents

FIG. 7

Q – flowrate; BOD – Biochemical oxygen demand; DO – Dissolved oxygen

FIG. 8

FIG. 9

Europäisches
Patentamt

European
Patent Office

Office européen
des brevets

# EUROPEAN SEARCH REPORT

**Application Number**

EP 24 20 0945

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | CN 116 542 387 A (ZHANG SHIZE) 4 August 2023 (2023-08-04) * paragraph [0020] - paragraph [0021] * ----- | 1-14 | INV. G06Q10/04 G06Q50/02 |
| Y | ZACH MOSHE ET AL: "HydroNets: Leveraging River Structure for Hydrologic Modeling", ARXIV.ORG, CORNELL UNIVERSITY LIBRARY, 201 OLIN LIBRARY CORNELL UNIVERSITY ITHACA, NY 14853, 1 July 2020 (2020-07-01), XP081713233, * cf. sections 2 (Problem Setting) and 3 (HydroNets) * ----- | 1-14 | |

**TECHNICAL FIELDS SEARCHED (IPC)**

G06Q

The present search report has been drawn up for all claims

| Place of search | Date of completion of the search | Examiner |
|---|---|---|
| Munich | 14 February 2025 | Reino, Bernardo |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

................................................................

& : member of the same patent family, corresponding
document

EPO FORM 1503 03.82 (P04C01)

## ANNEX TO THE EUROPEAN SEARCH REPORT
## ON EUROPEAN PATENT APPLICATION NO.

EP 24 20 0945

This annex lists the patent family members relating to the patent documents cited in the above-mentioned European search report.
The members are as contained in the European Patent Office EDP file on
The European Patent Office is in no way liable for these particulars which are merely given for the purpose of information.

14-02-2025

| Patent document cited in search report | Publication date | Patent family member(s) | Publication date |
|---|---|---|---|
| CN 116542387 A | 04-08-2023 | NONE | |

EPO FORM P0459

**REFERENCES CITED IN THE DESCRIPTION**

**Patent documents cited in the description**

- IN 202321074468